# EUROPÄISCHE PATENTSCHRIFT

(11) **EP 3 761 051 B1**
(45) Veröffentlichungstag und Bekanntmachung des Hinweises auf die Patenterteilung: **19.03.2025**
(21) Anmeldenummer: 19184394.5
(22) Anmeldetag: 04.07.2019
(51) Int. Cl.: G01R 33/34, G01R 33/3415, G01R 33/36

(54) **LOKALSPULE MIT SEGMENTIERTER ANTENNENVORRICHTUNG**
LOCAL COIL WITH SEGMENTED ANTENNA DEVICE
BOBINE LOCALE POURVUE DE DISPOSITIF D'ANTENNE SEGMENTÉ

(43) Veröffentlichungstag der Anmeldung: 06.01.2021
(73) Patentinhaber: Siemens Healthineers AG, 91301 Forchheim (DE)
(72) Erfinder: Rehner, Robert, 91077 Neunkirchen am Brand (DE); Zink, Stephan, 91054 Erlangen (DE); Kundner, Thomas, 91054 Buckenhof (DE)
(74) Vertreter: Siemens Healthineers Patent Attorneys

(56) Entgegenhaltungen:
- WO-A1-2005/052621
- WO-A1-2018/069247
- DE-A1- 102006 055 136
- DE-A1- 102011 079 564
- US-A- 5 168 230
- US-A1- 2007 262 777
- US-A1- 2013 137 969

## Beschreibung

Die Erfindung betrifft eine Lokalspule für einen Magnetresonanztomographen mit einer Antennenvorrichtung, wobei die Antennenvorrichtung eine Leiterschleife und eine Mehrzahl an elektronischen Funktionsgruppen aufweist.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt.

Um einen möglichst guten Signal-zu-Rausch-Abstand (Signal-to-Noise Ratio, SNR) zu erzielen, wird versucht, die Antennenspulen für den Empfang möglichst nahe am Patient anzuordnen. Dies erfolgt mit sogenannten Lokalspulen, die üblicherweise mit Kabelverbindungen an den Magnetresonanztomographen angeschlossen werden. Um die Nutzung zu vereinfachen und die Anzahl an unterschiedlichen Varianten zu reduzieren, gibt es Lokalspulen-Arrays bzw. - Matrizen die für unterschiedliche Zwecke verwendbar sind. Dabei sind jedoch starre Kabelverbindungen und voluminöse Elektronik-Elemente in dem Lokalspulen-Array hinderlich.

Aus dem Dokument WO 2005/052621 Al ist ein Magnetresonanztomograph mit einer Lokalspule bekannt. Die Lokalspule weist eine Hochfrequenzantenne auf mit elektronischen Baugruppen angeordnet auf einem Substrat. Die elektronischen Baugruppen sind mit der Hochfrequenzantenne elektrisch verbunden, in einem zentralen Bereich der Hochfrequenzantenne angeordnet und von der Hochfrequenzantenne umgeben.

Das Dokument US 2013/0137969 A1 beschreibt eine Magnetresonanzantennenmatrix mit einem Substrat und einem Gehäuse und in dem Gehäuse eingeschlossenen elektronische Schaltkreise. Die Schaltkreise sind elektrisch mit Antennenelementen gekoppelt.

Aus dem Dokument US 2007/0262777 Al ist eine Lokalspule mit niedrigem Querschnitt, die ausgelegt ist, resonant auf einer Magnetresonanzfrequenz des Magnetresonanzsystem zu sein. Eine flache Induktionsspule ist mit der Antenne gekoppelt. Die Induktionsspule stellt eine selektive Frequenzfilterung für Hochfrequenzsignale bereit, die von der Antenne empfangen oder gesendet werden.

Das Dokument US 5168230 A beschreibt ein MR-Spulenpaar für zwei unterschiedliche Larmorfrequenzen bzw. Kerne. Es weist zwei individuelle Spulen auf, die auf zwei unterschiedliche Resonanzfrequenzen abgestimmt sind. Die Spulen sind mit gleichem Umriss ausgeführt und mit geringem Abstand übereinandergelegt.

Aus dem Dokument WO 2018/069247 A1 ist eine Hochfrequenzantenne für ein Magnetresonanzsystem bekannt. Die Antenne weist einen gedruckten Schaltkreis auf, eine Mehrzahl an Leiterelementen auf dem Schaltkreis, eine Mehrzahl an Speisepunkten zur Anregung der Leiterelemente, einen Anschlussport und mehrere Speiseleitungen, die den Anschlussport mit den Speisepunkten verbinden.

Das Dokument DE 102006055136 A1 beschreibt eine Hochfrequenzspulenanordnung, umfassend mehrere Grundspulen bildende Leiterbahnen mit darin verschalteten Kapazitäten, wobei sich Leiterbahnen verschiedener Grundspulen an Knotenpunkten überschneiden. Zumindest an einem Teil der Knotenpunkte ist wenigstens ein Schaltmittel zur selektiven, reversiblen Verbindung der Leiterbahnen zur Bildung unterschiedlicher Spulengeometrien vorgesehen.

Aus der Druckschrift DE 102011079564 A1 ist eine Lokalspule für ein Magnetresonanztomographiegerät bekannt. Die Lokalspule weist einen biegbaren Antennenträgerteil mit mehreren Antennen und einen Elektronikteil mit Elektronikkomponenten auf, die mit den Antennen über Zuleitungen verbunden sind. Zumindest ein Teil des Elektronikteils befindet sich außerhalb des Antennenträgerteils.

Es stellt sich daher die Aufgabe, Lokalspulen für eine vielseitige Anwendung zu verbessern.

Die Aufgabe wird durch eine erfindungsgemäße Lokalspule nach Anspruch 1 gelöst.

Die erfindungsgemäße Lokalspule für einen Magnetresonanztomographen weist eine Antennenvorrichtung mit einer Leiterschleife und eine Mehrzahl an elektronischen Funktionsgruppen auf. Als Antennenvorrichtung wird dabei eine elektrische Einrichtung angesehen, die ausgelegt ist, elektrische und/oder magnetische Wechselfelder in einem vorbestimmten Frequenzbereich aus einem an die Lokalspule angrenzendem Raumvolumen zu empfangen und als elektrische oder optische Signale über eine Signalverbindung oder eine drahtlose Verbindung an den Magnetresonanztomographen zur Bildgebung weiterzuleiten. Vorzugsweise handelt es sich bei den Wechselfeldern um Magnetresonanzsignale von angeregten Kernspins aus einem Patienten mit einer als Larmorfrequenz bezeichneten Frequenz, die durch die Art der Kernspins und ein statisches Magnetfeld B0 des Magnetresonanztomographen bestimmt sind. Die Leiterschleife ist dabei als Induktionsschleife ausgelegt.

Die elektronischen Funktionsgruppen der erfindungsgemäßen Lokalspule sind voneinander beabstandet verteilt angeordnet. Die Funktionsgruppen sind entlang der Erstreckung der Leiterschleife angeordnet sind. Die elektronischen Funktionsgruppen sind alternativ an bzw. zwischen flexiblen Leitersegmenten angeordnet, die einzelne Leiterschleifen zu einer Antennenmatrix bzw. einem Antennenarray verbinden. Als elektronische Funktionsgruppen werden dabei Vorverstärker (LNA, low noise amplifier), Symmetrierglieder (BALUN, balancer/unbalancer), Mischer, Diplexer, Impedanzanpassungsnetzwerke und Sicherungsschaltungen zum Schutz der Antenne und/oder des Patienten angesehen. Als elektronische Funktionsgruppe werden jeweils alle Bauelemente angesehen, die zur Erfüllung einer einzelnen dieser Funktionen zusammenwirken müssen und deshalb als Gruppe auch räumlich benachbart zueinander angeordnet sind.

Die elektronischen Funktionsgruppen sind dabei durch flexible Leitersegmente elektrisch miteinander verbunden. Flexible Leitersegmente sind dabei elektrische Leiter, die Teilabschnitte der Leiterschleife bilden und durch geringe Krafteinwirkungen, beispielsweise durch das Eigengewicht der elektronischen Funktionsgruppen, sich der Form des Patienten anpassen. Denkbar ist es auch, dass die Lokalspule durch eine Bedienperson mit manueller Kraft in eine gewünschte Form gebracht werden kann. Dazu kann die Lokalspule beispielsweise auch eine Hülle aus einem flexiblen Material aufweisen oder in mehrere gegeneinander schwenkbar verbundene Segmente gegliedert sein.

Grundsätzlich ist es auch denkbar, dass die Leiterschleife von einem einzigen flexiblen Leitersegment gebildet wird.

Auf vorteilhafte Weise lässt sich durch die Kombination aus über die Lokalspule verteilten elektronischen Funktionsgruppen und deren flexible Verbindung eine Lokalspule bereitstellen, die eine gleichmäßigere Dicke und Flexibilität bei gleichzeitiger Vermeidung von konzentrierten Wärmequellen durch zentrale Elektronik bereitstellt.

Bei der erfindungsgemäßen Lokalspule sind Bauelemente einer elektronischen Funktionsgruppe unmittelbar auf einem flexiblen Leitersegment angeordnet sind. Als unmittelbar wird dabei angesehen, dass die Bauelemente nicht erst auf einer Leiterplatte angeordnet und dann mit dieser mit dem flexiblen Leitersegment verbunden sind. Die elektronischen Bauelemente können dabei beispielsweise mit dem flexiblen Leitersegment verlötet sein. Das flexible Leitersegment kann insbesondere bei einer Ausführungsform mit mehr als zwei Leiterebenen auch Leiterbahnen und/oder leitende Durchverbinder zur Verbindung bzw. Entflechtung von Bauelementen der elektronischen Funktionsgruppe bereitstellen.

Insbesondere bei einfachen elektronischen Funktionsgruppen mit kleinen, robusten Bauelementen ermöglicht die Anordnung der Bauelemente unmittelbar auf dem flexiblen Leitersegment eine platzsparende Bauweise. Beispielsweise müssen Detune-Schaltkreise mit wenigen Bauelementen über die Leiterschleife an bestimmten Positionen verteilt sein, um optimale Wirkung zu erzielen. Diese Art der Anordnung eignet sich besonders für Bereiche, in denen das flexible Leitersegment geringen mechanischen Belastungen und/oder Verformungen unterworfen ist. Es ist auch denkbar, dass einzelne sensitive Bauelemente durch eigene Rahmen oder Gehäuse vor mechanischen Belastungen geschützt werden.

Für mechanisch empfindliche Bauelemente und stärker belastete bzw. bewegte Abschnitte der flexiblen Leitersegmente kann es hingegen vorteilhaft sein, in diesem Abschnitt an der erforderlichen Stelle jeweils eine elektronische Funktionsgruppe anzuordnen und das Bauelement auf die elektronische Funktionsgruppe zu verlagern.

Erfindungsgemäß ist das flexible Leitersegment im Bereich der elektronischen Funktionsgruppe versteift. Die Versteifung wird erfindungsgemäß ausgeführt, indem am Ort der Funktionsgruppe ein steiferes Trägermaterial in dem flexiblen Leitersegment vorgesehen ist, zusätzliche Schichten des Trägermaterials vorgesehen sind und/oder eine Schicht des Trägermaterials dicker ausgeführt ist als in dem benachbarten flexiblen Bereich.

Dies ist beispielsweise für Verlängerungskondensatoren oder Verstimm-Dioden denkbar. Dabei kann dann beispielsweise die zur Ansteuerung der Verstimm-Diode erforderliche Schaltung mit auf der elektronischen Funktionsgruppe angeordnet werden um so eine sinnvolle Verteilung der starren, schweren und/oder Abwärme erzeugenden Elemente zu erreichen. Aber auch komplexere Funktionen können mit einer direkten Bestückung auf einem versteiften Bereich eines flexiblen Leitersegments realisiert werden.

Weitere vorteilhafte Ausführungsformen sind in den abhängigen Ansprüchen angegeben.

In einer denkbaren Ausführungsform der erfindungsgemäßen Lokalspule weisen die flexiblen Leitersegmente eine flexible Leiterplatte mit mindestens drei Lagen auf. Herkömmliche flexible Leiterplatten bestehen aus einem isolierenden Trägermaterial mit Leiterflächen, auch als Lagen bezeichnet, die auf gegenüberliegenden Oberflächen des Trägermaterials angeordnet sind. Die flexiblen Leitersegmente gemäß der Erfindung hingegen weisen mindestens eine weitere Lage aus einem Leiter und eine isolierende Zwischenschicht auf, sodass zusätzliche Kontroll- und Signalverbindungen zwischen den elektronischen Funktionsgruppen bereitgestellt werden können. Auch ist es denkbar, dass mittels der zusätzlichen Leiter-und Isolator-Flächen Kapazitäten, beispielsweise zur kapazitiven Spulenvergrößerung, bereitgestellt werden. Die flexiblen Leitersegmente können dabei mechanisch getrennt ausgeführt sein, sodass diese erst durch die elektronischen Funktionsgruppen mechanisch miteinander verbunden sind, oder auch nur elektrisch getrennt sein, sodass lediglich eine oder mehrere elektrische Verbindungen zwischen den flexiblen Leitersegmenten erst durch die elektronische Funktionsgruppe hergestellt werden.

Auf vorteilhafte Weise ermöglicht eine flexible Leiterplatte mit mindestens drei Lagen die Realisierung von Steuer- und Signalleitungen ohne separate, frei verdrahtete Leitungen. Mittels der Leiterflächen in Multischicht-Technik bereitgestellte Kapazitäten vermeiden dabei auf vorteilhafte Weise diskrete Kapazitäten, deren mechanische Eigenschaften bei der Verarbeitung auf flexiblen Trägermaterialien besonders störanfällig sind.

In einer möglichen Ausführungsform der erfindungsgemäßen Lokalspule weist ein flexibles Leitersegment eine geschirmte elektrische Signalleitung und/oder eine Steuerleitung für die elektronischen Funktionsgruppen auf. Als geschirmte Signalleitung wird dabei eine Signalleitung in einer mehrlagigen flexiblen Leiterplatte angesehen, bei der die Abschirmwirkung vergleichbar einer koaxialen Abschirmung um eine Seele eines konventionellen Koaxialkabels durch zu einer Signalleitung in einer flexiblen Leiterplatte benachbarten Leiterflächen in der mehrlagigen flexiblen Leiterplatte erzielt wird. Vorzugsweise stehen dabei die benachbarten Leiterflächen in Signalverbindung mit einer Bezugsmasse der Signale. Die Signalleitung kann dabei vergleichbar einer Koaxialleitung mit einer asymmetrischen Ader oder differenziell durch zwei symmetrische Signaladern bereitgestellt sein. Eine Steuerleitung ist hierbei eine Signalleitung, die ausgelegt ist, ein Signal für die Funktion einer elektrischen Funktionsgruppe zu übertragen, das nicht ein Magnetresonanzsignal ist. Vorzugsweise sind dies Hilfs-oder Steuersignale, die von dem Magnetresonanztomographen zu der Lokalspule übertragen werden, wie beispielsweise Detune-, Takt- oder Hilfsfrequenzsignale und Versorgungsspannungen.

Aufgrund höherer Signalpegel oder anderweitig bedingter Einstrahlfestigkeit kann hierbei auch eine Abschirmung durch benachbarte Leiterflächen entfallen.

Auf vorteilhafte Weise kann durch zusätzliche Signalleitungen in dem flexiblen Leitersegment der mechanische Aufbau der Antennenvorrichtung vereinfacht werden.

In einer denkbaren Ausführungsform der erfindungsgemäßen Lokalspule weist ein flexibles Leitersegment eine Mantelwellensperre auf. Insbesondere in flexiblen Leitersegmenten zwischen einzelnen Leiterschleifen einer Antennenmatrix mit größeren Abmessungen können Mantelwellensperren erforderlich sein, um eine Überlastung der Schaltung oder eine Gefährdung von Patienten durch induzierte Ströme und Spannungen zu vermeiden. Als Mantelwellensperre wird insbesondere ein Filter angesehen, der die Ausbreitung eines elektrischen Signals mit der Larmorfrequenz über einen oder mehrere Leiter des flexiblen Leitersegments verhindert. Ein derartiges Signal wird beispielsweise induziert, wenn der Magnetresonanztomograph zur Anregung der zu untersuchenden Kernspins ein Hochfrequenzsignal mit der Larmorfrequenz aussendet. Dabei ist das flexible Leitersegment in einer bevorzugten Ausführungsform als Teil der Mantelwellensperre zu einer Trommel bzw. Spule aufgerollt.

Auf vorteilhafte Weise kann durch ein Aufrollen des flexiblen Leitersegments zu einer Trommel oder Spule ohne zusätzliche Leiter oder Verbindungsstellen eine Induktivität für eine Mantelwellensperre bereitgestellt werden.

In einer möglichen Ausführungsform der erfindungsgemäßen Lokalspule weist die Lokalspule eine Mehrzahl an Antennenvorrichtungen mit einer Mehrzahl an Antennenschleifen auf. Dabei können die Antennenvorrichtungen alle gleichartig sein oder auch unterschiedlichen, zuvor beschriebenen Ausführungsformen angehören. Die Antennenvorrichtungen bilden dabei vorzugsweise eine Matrix aus, bei der sich die von den Leiterschleifen umschlossenen Flächen nur teilweise überdecken und jeweils einzeln zumindest teilweise disjunkte Flächen überdecken, um Magnetresonanzsignale aus unterschiedlichen Bereichen des Untersuchungsobjektes aufzunehmen. Die Mehrzahl an Antennenvorrichtungen weist dabei Steckverbindungen an den Leiterschleifen auf, mit denen die Antennenvorrichtungen elektrisch und auch mechanisch miteinander verbunden sind. Denkbar ist es, dass auf diese Weise aus identischen Antennenvorrichtungen eine Antennenmatrix der Lokalspule gebildet ist. Die Steckvorrichtung kann dabei beispielsweise induzierte Magnetresonanzsignale zwischen den Leiterschleifen austauschen, um eine Entkopplung der Leiterschleifen bereitzustellen. Es ist aber auch denkbar, dass auf diese Weise Steuersignale, Takte, Oszillatorsignale oder auch Versorgungsspannungen und Ströme über die Antennenvorrichtungen der Lokalspule durch flexible Leitersegmente ohne zusätzliche freie Verdrahtung verteilt werden.

Auf vorteilhafte Weise ist über die Steckverbindungen zwischen den Leiterschleifen eine kostengünstige Bereitstellung einer Antennenmatrix der Lokalspule möglich.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Übersichtsdarstellung eines Magnetresonanztomographen mit einer erfindungsgemäßen Lokalspule;
- Fig. 2: eine schematische Darstellung einer Lokalspule aus dem Stand der Technik;
- Fig. 3: eine schematische Darstellung einer erfindungsgemäße Lokalspule mit einer beispielhaften Verteilung von Funktionsgruppen;
- Fig. 4: eine schematische Darstellung eines erfindungsgemäßen flexiblen Leitersegments.

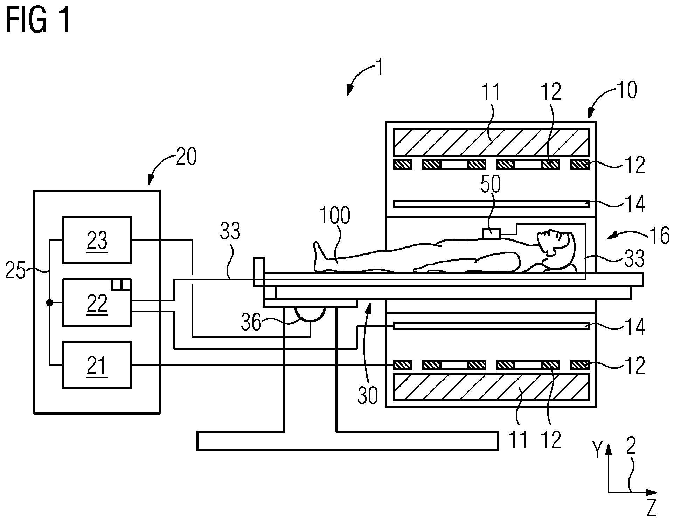

Fig. 1 zeigt eine schematische Darstellung einer Ausführungsform eines Magnetresonanztomographen 1 mit einer erfindungsgemäßen Lokalspule 50.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben. Vorzugsweise wird jedoch das Magnetresonanzsignal von dem Patienten von der nachfolgend näher ausgeführten Lokalspule 50 aufgenommen, die näher am Patienten 100 angeordnet ist.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, einer vorgegebenen Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungspulse können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22. Auf dem Patienten 100 ist die erfindungsgemäße Lokalspule 50 angeordnet, die in kabelgebundener oder auch drahtloser Signalverbindung mit der Hochfrequenzeinheit 22 steht.

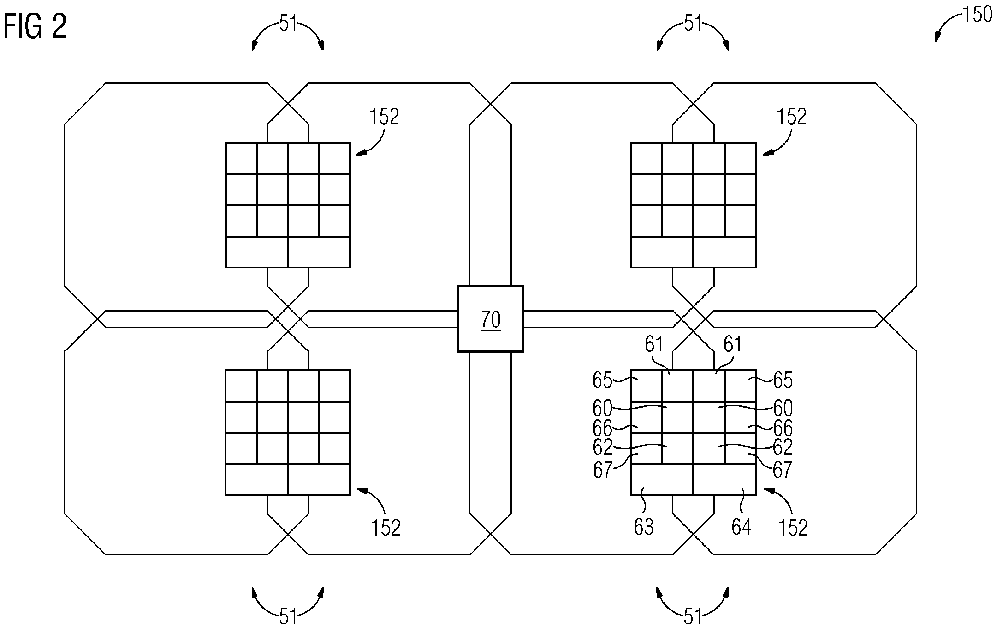

Fig. 2 zeigt eine schematische Darstellung einer herkömmlichen Lokalspule 150 aus dem Stand der Technik. Die herkömmliche Lokalspule 150 weist eine Mehrzahl an Leiterschleifen 51 auf, die eine Antennen-Matrix bzw. ein - Array bilden. Die Leiterschleifen 51 überlappen teilweise, um durch die entgegengesetzte Flussrichtung des Magnetfeldes in überlappenden und nicht überlappenden Bereichen eine Entkopplung zwischen benachbarten Leiterschleifen 51 herbeizuführen.

Zwischen zwei Leiterschleifen 51 ist bei der herkömmlichen Lokalspule 150 jeweils eine zentrale Elektronikbaugruppe 152 ausgeführt, auf der unterschiedliche Funktionsgruppen vereint sind. Dies sind beispielsweise Balun 60 und Anpassungsnetzwerk 65, mit denen die Impedanz und Symmetrie der Leiterschleife 51 an die erste Vorverstärkerstufe 61 angepasst werden. Weiterhin befinden sich zweite Vorverstärkerstufen 62 zur weiteren Verstärkung, Mischer 63 zum Umsetzen der verstärkten Magnetresonanzsignale auf eine Zwischenfrequenz und Diplexer zum Zusammenfassen bzw. Trennen von Signalen unterschiedlicher Frequenz, wie z.B. Oszillatorsignal, Zwischenfrequenzen und Verstimm-Signalen, auf den zentralen Elektronikbaugruppen 152.

Die Signale der zentralen Elektronikbaugruppe 152 werden über separate Signalleitungen zu einer zentralen Anschlusseinheit 70 zusammengeführt, an der ein Kabel direkt befestigt ist oder über einen Stecker an einer entsprechenden mehrpoligen Buchse auf der Anschlusseinheit 70 angeschlossen werden kann.

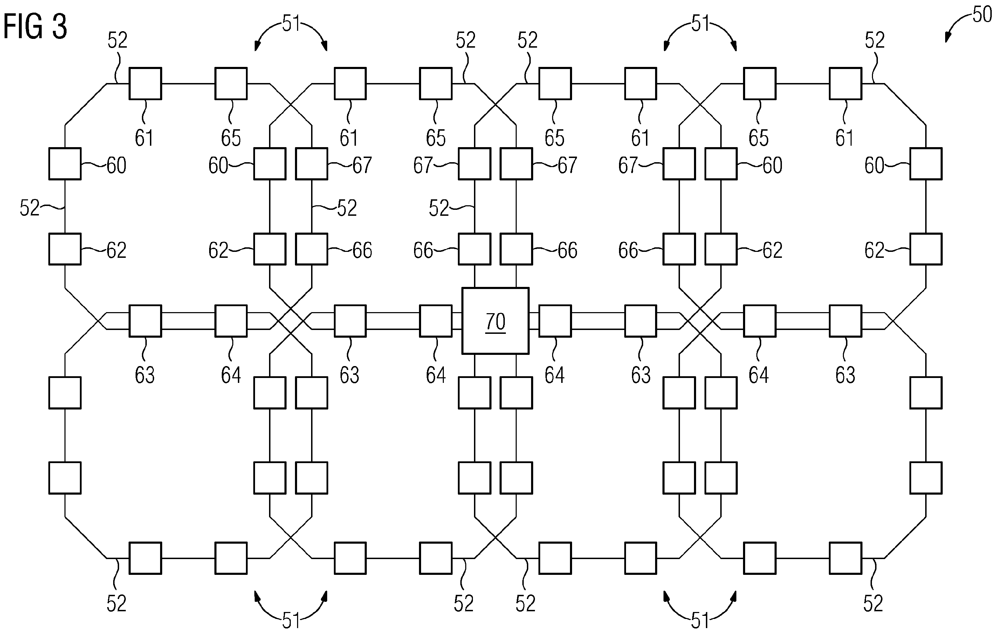

Die Fig. 3 zeigt demgegenüber eine erfindungsgemäße Lokalspule 50 mit einer beispielhaften Verteilung von Funktionsgruppen. Die Funktionsgruppen sind dabei durch flexible Leitersegmente 52 zu Leiterschleifen 51 verbunden. So sind beispielsweise Funktionsgruppen wie der Balun 60, der erste Vorverstärker 61, und das Anpassungsnetzwerk 65 durch flexible Leitersegmente 52 miteinander verbunden, aber gleichzeitig zueinander beabstandet entlang der Leiterschleife 51 angeordnet. Da der Balun 60 und das Anpassungsnetzwerk 65 für eine elektrische Anpassung der Signale der Leiterschleife 51 an die erste Vorverstärkerstufe 61 sorgen, ist es vorteilhaft, diese jeweils benachbart zueinander entlang der Erstreckung der Leiterschleife 51 anzuordnen. Gleiches gilt für die zweite Verstärkerstufe 62, die ihr Ausgangssignal über den Mischer 63 und den Diplexer 64 weitergibt. Auch diese sind daher vorzugsweise zueinander benachbart entlang der Leiterschleife 51 angeordnet.

Unmittelbarer Teil der geschlossenen Leiterschleife in dem Sinne, dass sie auch in die Leiterschleife 51 elektrisch eingebunden sind, sind dabei die Funktionseinheiten wie Sicherung 67, Verstimmschaltung 66, Anpassungsnetzwerk 65 oder erste Vorverstärkerstufe 61, die das von der Leiterschleife 51 als Antennenspule empfangene MR-Signal unmittelbar verarbeiten bzw. beeinflussen.

Da darüber hinaus der Mischer 63 und der Diplexer 64 die Signale zweier Leiterschleifen 51 zusammenfassen und weiterleiten, sind der Mischer 63 und der Diplexer 64 vorzugsweise in einem Bereich angeordnet, in dem zwei Leiterschleifen 51 überlappen, deren Signale dann zusammengefasst werden.

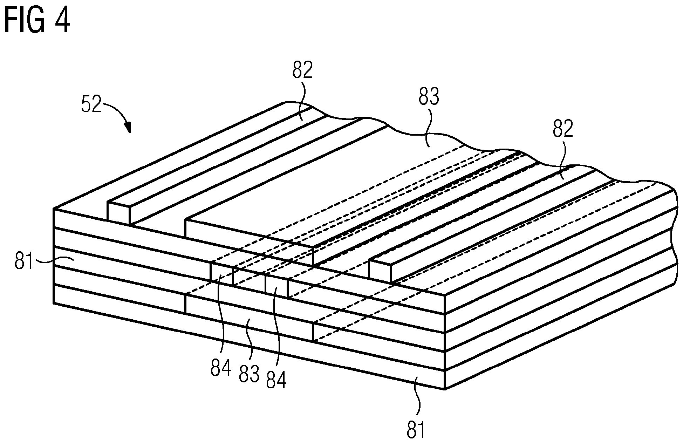

Die Leiterschleifen 51 sind an oder auf einem flexiblen Trägermaterial 81 angeordnet, wie es nachfolgend zu Fig.4 näher erläutert wird. Entlang der Leiterschleife 51, aber nicht unmittelbar in diese elektrisch eingebunden und auf dem gemeinsamen flexiblen Trägermaterial 81 angeordnet, sind weitere Funktionseinheiten, wie die bereits angeführten Mischer 63, Diplexer 64 oder zweite Verstärkerstufen 62 und Balun 60. Diese sind durch separate Leiter auf dem flexiblen Trägermaterial 81 als Versorgungs-, Signal- oder Steuerleitungen mit den anderen Einheiten und/oder der Anschlusseinheit 70 verbunden

Dabei sind eine oder mehrere elektronische Funktionsgruppen unmittelbar auf dem flexiblen Leitersegment 52 ausgebildet, indem das flexible Leitersegment die Verbindungs- und Versorgungsleitungen bereitstellt und die Bauelemente direkt auf dem flexiblen Leitersegment 52 bestückt sind. Zur mechanischen Entlastung der Bauelemente der elektronischen Funktionsbaugruppe sind dann in dem Bereich der Bestückung mit den Bauelementen zusätzliche Schichten des flexiblen Trägermaterials 81 vorgesehen, das flexible Trägermaterial 81 in einer oder mehreren Schichten in diesem Bereich dicker ausgeführt und/oder Schichten mit einem steiferen Trägermaterial ausgeführt, sodass das flexible Leitersegment 52 in dem Bereich der elektronischen Funktionsgruppe versteift ist und mechanische Kräfte auf die Bauelemente und die Lötverbindungen wesentlich reduziert. Auf vorteilhafte Weise kann so die Funktionsbaugruppe einstückig mit dem flexiblen Leitersegment ausgeführt werden und fehleranfällige Verbindungen vermieden werden.

In nicht beanspruchten Ausführungsformen können die Funktionsgruppen aber auch als ein- oder mehrlagige separate Leiterplatten ausgeführt sein. Die Leiterplatten können starr ausgeführt sein, um empfindliche Bauelemente wie keramische Kondensatoren, die darauf befestigt bzw. gelötet sind, gegen mechanischen Stress zu schützen. Vorzugsweise sind dann die einzelnen Leiterplatten in ihrer Erstreckung parallel zur Leiterschleife 51 klein ausgeführt, beispielweise kleiner als die Hälfte, ein Drittel oder ein Viertel einer Erstreckung eines verbindenden flexiblen Leitersegments 52. So weist die gesamte Leiterschleife 51 als Verbund flexibler und starrer Elemente dennoch eine ausreichende Flexibilität aus. Grundsätzlich ist es aber auch denkbar, für weniger empfindliche Bauelemente auch die Leiterplatte einer Funktionsgruppe flexibel auszulegen.

Eine Verbindung zwischen Funktionsgruppe und flexiblem Leitersegment 52 erfolgt vorzugsweise bei separaten Leiterplatten durch eine formschlüssige und/oder kraftschlüssige, elektrisch leitende Verbindung. Beispielsweise kann die Leiterplatte der Funktionsgruppe durch ein komplementäres Stecker-Buchse-System miteinander verbunden sein. Denkbar ist auch eine Klemmvorrichtung, mittels der das flexible Leitersegment 52 elektrisch und mechanisch verbunden ist.

Fig. 4 stellt ein erfindungsgemäßes flexibles Leitersegment 52 schematisch dar. Das flexible Leitersegment 52 weist mehrere Schichten eines flexiblen Isolators als flexibles Trägermaterial 81 auf. Vorzugsweise ist dieses flexible Trägermaterial 81 ein Dielektrikum mit hoher Güte und geringen dielektrischen Verlusten. Zwischen oder auch auf diesen flexiblen Trägermaterialien 81 sind Lagen eines Leitermaterials angeordnet. Das Leitermaterial ist beispielsweise als Folien oder Drähte aus gut leitendem Material bzw. Metall wie Kupfer, Silber, Aluminium ausgebildet. Diese können flächig als Schirmflächen 83 oder auch als Leiterbahnen 82, 84 ausgebildet sein. Leiterbahnen 82, die nicht von Schirmflächen 83 umgeben sind, können beispielsweise als Leiterschleife 51 zum Empfang von Magnetresonanzsignalen ausgebildet sein. Hingegen können Leiterbahnen 84, die zwischen zwei Schirmflächen 83 angeordnet sind, zum Weiterleiten von Magnetresonanzsignalen und/oder Steuersignalen vorgesehen sein. Mit vorbestimmten Abständen untereinander und zu den Schirmflächen können dabei elektrische Eigenschaften in Bezug auf Wellenwiderstand und Störeinstrahlung erzielt werden, die vergleichbar zu Koaxialkabeln, oder bei zwei parallelen Leiterbahnen, vergleichbar zu geschirmten symmetrischen Leitungen sind. Symmetrische Leitungen sind hier vorteilhaft, da beispielsweise die Antennenschleifen selbst symmetrische Signale bereitstellen. Dabei ist es auch denkbar, dass zwischen zwei Schichten des flexiblen Trägermaterials 81 im Zwischenraum der zwei Leiterbahnen in der Ebene kein Trägermaterial, sondern ein anderes Dielektrikum, auch Luft, sein kann.

Mittels der in Fig. 4 dargestellten grundsätzlichen Möglichkeiten zur Gestaltung eines flexiblen Leitersegments 52 lassen sich verschiedene Kombinationen und Funktionen realisieren. Denkbar wäre es beispielsweise, dass die Leiterbahnen 82 an der Oberfläche Teil einer Leiterschleife 51 einer Antenne bilden. Dabei kann es auch vorgesehen sein, dass auf gegenüberliegenden Oberflächen des Leitersegments elektrisch miteinander verbundene Leiterbahnen 82 vorgesehen sind, die aufgrund des Skin-Effektes einen separaten, dicken Leiter ersetzen können. Im Inneren können geschirmte Steuer-und Signalleitungen gebildet werden, die auch Leiterschleifen 51 untereinander zu einer Matrix zusammenschließen oder mit einer Anschlusseinheit 70 zum Anschluss an den Magnetresonanztomographen 1 verbinden. Auch Versorgungsspannungen bzw. Ströme können auf diese Weise zu den Funktionsgruppen geleitet werden.

Das flexible Leitersegment 52 kann aber auch weitere elektrische Funktionen bereitstellen. Durch gegenüberliegende Leiterflächen vergleichbar den Schirmflächen 83, jedoch ohne Leiterbahn 81 dazwischen, nur durch ein Dielektrikum getrennt und elektrisch voneinander isoliert, können Kapazitäten bereitgestellt werden, die beispielsweise aufgelötete Verlängerungskapazitäten ersetzen.

In Bereichen, in denen ein flexibles Leitersegment 52 durch Bestückung gleichzeitig als elektronische Funktionsbaugruppe ausgeführt ist, können eine oder mehrere der Schichten des flexiblen Trägermaterials 81 durch eine größere Dicke als Versteifung ausgeführt sein und/oder zusätzliche Schichten aus gleichem Trägermaterial oder auch steiferem Material diesen Zweck erfüllen, um die aufgebrachten Bauelemente gegen mechanische Spannungen durch Biegung und Verwindung zu schützen.

Durch Aufrollen eines flexiblen Leitersegments 52 zu einer Trommel bzw. Spule kann auch die Induktivität der Leiterbahnen 81 in dem flexiblen Leitersegment 52 vergrößert bzw. gesteuert werden. Weiterhin ist es denkbar, das flexible Leitersegment durch einen Sperrtopf zu führen oder um einen Kern zu wickeln. Dadurch und auch in Verbindung mit den Kapazitäten können so auch Mantelwellensperren bereitgestellt werden, die stehende Wellen insbesondere auf Verbindungen zwischen den Leiterschleifen verhindern.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, der durch die Ansprüche definiert wird.

## Patentansprüche

1. Lokalspule für einen Magnetresonanztomographen (1) mit einer Antennenvorrichtung, wobei die Antennenvorrichtung eine Leiterschleife (51) und eine Mehrzahl an elektronischen Funktionsgruppen aufweist, wobei eine Funktionsgruppe eines aus Vorverstärker, Symmetrierglied, Mischer, Diplexer, Impedanzanpassungsnetzwerke und Sicherungsschaltungen zum Schutz der Antenne und/oder des Patienten ist,
wobei die elektronischen Funktionsgruppen voneinander beabstandet verteilt angeordnet sind und durch flexible Leitersegmente (52) elektrisch miteinander verbunden sind, wobei die elektronischen Funktionsgruppen entlang der Erstreckung der Leiterschleife angeordnet sind und/oder die Antennenvorrichtung eine Mehrzahl an Leiterschleifen aufweist und die elektronischen Funktionsgruppen an bzw. zwischen flexiblen Leitersegmenten angeordnet sind, die einzelne Leiterschleifen zu einer Antennenmatrix verbinden,**dadurch gekennzeichnet, dass** Bauelemente einer elektronischen Funktionsgruppe unmittelbar auf einem flexiblen Leitersegment (52) angeordnet sind, wobei die Bauelemente nicht auf einer Leiterplatte angeordnet und mit dieser mit dem flexiblen Leitersegment verbunden sind,
wobei das flexible Leitersegment (52) im Bereich der elektronischen Funktionsgruppe eine Versteifung aufweist,
wobei die Versteifung ein steiferes Trägermaterial in dem flexiblen Leitersegment und/oder zusätzliche Schichten eines Trägermaterials und/oder eine Schicht des Trägermaterials dicker im Vergleich zu dem benachbarten flexiblen Bereich aufweist.

2. Lokalspule nach Anspruch 1, wobei die flexiblen Leitersegmente (52) eine flexible Leiterplatte mit mindestens drei Lagen aufweisen.

3. Lokalspule nach Anspruch 1, wobei ein flexibles Leitersegment (52) eine geschirmte elektrische Signalleitung und/oder eine Steuerleitung für die elektronischen Funktionsgruppen aufweist.

4. Lokalspule nach Anspruch 1, wobei ein flexibles Leitersegment (52) eine Mantelwellensperre aufweist, wobei in der Mantelwellensperre das flexible Leitersegment (52) zu einer Trommel aufgerollt ist.

5. Lokalspule nach einem der vorhergehenden Ansprüche, wobei die Lokalspule (50) eine Mehrzahl an Antennenvorrichtungen mit einer Mehrzahl an Leiterschleifen (51) aufweist und die Mehrzahl an Antennenvorrichtungen elektrisch leitende Verbindungen an den Leiterschleifen (51) aufweist, mit denen die Antennenvorrichtungen elektrisch miteinander verbunden sind.

## Claims

1. Local coil for a magnetic resonance tomography scanner (1) having an antenna device, wherein the antenna device has a conductor loop (51) and a plurality of electronic function groups, wherein a function group is one of preamplifiers, baluns, mixers, diplexers, impedance matching networks, and safety circuits for protection of the antenna and/or patient, wherein the electronic function groups are arranged in a distributed manner spaced apart from one another and are electrically connected to one another by flexible conductor segments (52), wherein the electronic function groups are arranged along the extension of the conductor loop and/or the antenna device has a plurality of conductor loops and the electronic function groups are arranged on or between flexible conductor segments, the individual conductor loops connect to form an antenna matrix, **characterised in that**
components of an electronic function group are arranged directly on a flexible conductor segment (52), wherein the components are not arranged on a circuit board and are connected by the circuit board to the flexible conductor segment,
wherein the flexible conductor segment (52) has a bracing in the region of the electronic function group,
wherein the bracing has a stiffer carrier material in the flexible conductor segment and/or additional layers of a carrier material and/or a layer of the carrier material thicker in comparison to the adjacent flexible region.

2. Local coil according to claim 1, wherein the flexible conductor segments (52) have a flexible circuit board with at least three layers.

3. Local coil according to claim 1, wherein a flexible conductor segment (52) has a shielded electrical signal line and/or a control line for the electronic function groups.

4. Local coil according to claim 1, wherein a flexible conductor segment (52) has a standing wave trap, wherein the flexible conductor segment (52) is rolled up to form a drum in the standing wave trap.

5. Local coil according to one of the preceding claims, wherein the local coil (50) has a plurality of antenna devices with a plurality of conductor loops (51) and the plurality of conductor devices has electrically conductive connections on the conductor loops (51), with which the antenna devices are electrically connected to one another.

## Revendications

1. Bobine locale d'un tomodensitomètre (1) par résonance magnétique comprenant un dispositif d'antenne, dans laquelle le dispositif d'antenne a une boucle (51) de conducteur et une pluralité de groupes électroniques fonctionnels, dans laquelle un groupe fonctionnel est l'un d'un préamplificateur, d'un organe de symétrisation, d'un mélangeur, d'un diplexeur, de réseaux d'adaptation d'impédance et de circuits de sécurisation pour la protection de l'antenne et/ou du patient,
dans laquelle les groupes électroniques fonctionnels sont disposés de manière répartie en étant à distance les uns des autres et sont connectés entre eux électriquement par des segments (52) de conducteur souples, dans laquelle les groupes électroniques fonctionnels sont disposés le long de l'étendue de la boucle de conducteur et/ou le dispositif d'antenne a une pluralité de boucles de conducteur et les groupes électroniques fonctionnels sont disposés sur ou entre des segments de conducteur souples, qui connectent les boucles de conducteur individuelles en une matrice d'antenne, **caractérisée en ce que**
des éléments de construction d'un groupe électronique fonctionnel sont disposés directement sur un segment (52) de conducteur souple, dans laquelle les éléments de construction ne sont pas disposés sur une plaquette à circuit imprimé et sont connectés à celle-ci par le segment de conducteur souple,
dans laquelle le segment (52) de conducteur souple a, dans la partie du groupe électronique fonctionnel un raidissement, dans laquelle le raidissement a un matériau de support plus rigide dans le segment de conducteur souple et/ou des couches supplémentaires d'un matériau de support et/ou une couche de matériau de support plus épaisse que la partie souple voisine.

2. Bobine locale suivant la revendication 1, dans laquelle les segments (52) de conducteur souples ont une plaquette à circuit imprimé souple ayant au moins trois couches.

3. Bobine locale suivant la revendication 1, dans laquelle un segment (52) conducteur souple a une ligne de signalisation électrique blindée et/ou une ligne de commande des groupes électroniques fonctionnels.

4. Bobine locale suivant la revendication 1, dans laquelle un segment (52) conducteur souple a un blocage d'ondes d'enveloppe, dans lequel, dans le blocage d'ondes d'enveloppe, le segment (52) conducteur souple est enroulé en un tambour.

5. Bobine locale suivant l'une des revendications précédentes, dans laquelle la bobine (50) locale a une pluralité de dispositifs d'antenne ayant une pluralité de boucles (51) de conducteur et la pluralité de dispositifs d'antenne a des connexions conductrices d'électricité sur les boucles (51) de conducteur, par lesquelles les dispositifs d'antenne sont connectés entre eux électriquement.
